# EUROPÄISCHE PATENTSCHRIFT

(11) **EP 2 897 897 B1**
(45) Veröffentlichungstag und Bekanntmachung des Hinweises auf die Patenterteilung: **09.11.2016**
(21) Anmeldenummer: 13766277.1
(22) Anmeldetag: 20.09.2013
(51) Int. Cl.: B81C 3/00

(54) **VERFAHREN UND VORRICHTUNG ZUM ANORDNEN VON KLEINTEILEN**
METHOD AND DEVICE FOR ARRANGING SMALL PARTS
PROCÉDÉ ET DISPOSITIF PERMETTANT D'AGENCER DES PIÈCES DE PETITE DIMENSION

(30) Priorität: 21.09.2012 DE 102012018747
(43) Veröffentlichungstag der Anmeldung: 29.07.2015
(73) Patentinhaber: FRAUNHOFER-GESELLSCHAFT zur Förderung der angewandten Forschung e.V., 80636 Munich (DE)
(72) Erfinder: OTHMAN, Nabih, 70771 Musberg (DE); BURGARD, Matthias, 70178 Stuttgart (DE); MAI, Uwe, 71139 Ehningen (DE)
(74) Vertreter: Pfenning, Meinig & Partner mbB
(86) Internationale Anmeldenummer: PCT/EP2013/069616
(87) Internationale Veröffentlichungsnummer: WO 2014/044816

(56) Entgegenhaltungen:
- US-A1- 2010 266 769

## Beschreibung

Die Erfindung betrifft ein Verfahren und eine Vorrichtung zum Anordnen von Kleinteilen, wobei ein Flüssigkeitsvolumen mit einer zumindest bereichsweise gekrümmten Oberfläche angelegt wird und eine Vielzahl der zu vereinzelnden Kleinteile auf den gekrümmten Bereich der Oberfläche aufgebracht wird. Die Kleinteile werden von der Flüssigkeit durch die Oberflächenspannung und/oder den Auftrieb getragen und bewegen sich in Folge der Krümmung der Oberfläche in eine Zwischenposition. Durch Vibration werden die Kleinteile dann in eine Anordnungsposition gebracht in der sie angeordnet vorliegen.

Nach dem Stand der Technik werden Kleinteile und Kleinstteile, wie sie unter anderem in der Mikrosystemtechnik vorkommen, mittels verschiedener Verfahren angeordnet, vereinzelt und bereitgestellt.

Beispiele für entsprechende Kleinteile sind elektronische Komponenten wie beispielsweise LEDs, Widerstände usw. oder optische, wie beispielsweise Linsen, Spiegel usw., oder mechanische Bauteile, wie beispielsweise Kugeln, Schrauben, Federn, Scheiben, Zahnräder usw. Die Kleinteile können beliebige Materialien aufweisen, wie beispielsweise Metalle, Polymere, Keramik, Halbleiter oder natürliche Stoffe.

In einem Verfahren nach dem Stand der Technik können Kleinteile durch Vibration vereinzelt werden (Schwingförderer). Hierbei werden im Schüttgut vorliegende Bauteile mit Vibrationsfördertechnik vereinzelt und transportiert.

Derartige Systeme gibt es in unterschiedlichen Ausführungen (Material und Form) und in unterschiedlichen Frequenzbereich arbeitend. Ein gegebenenfalls erforderliches Aussortieren von falsch liegenden oder fehlerhaften Teilen erfolgt durch eine im Förderweg integrierte Auswerfervorrichtung.

Alternativ kann nach dem Stand der Technik eine Vereinzelung durch eine schräge Ebene durchgeführt werden. Hierbei werden Kleinteile auf eine schiefe Ebene aufgebracht und rutschen auf dieser ab. Dabei ist es möglich, dass sich die Teile entlang einer Anschlagkante mit einer Vereinzelungsstruktur anlegen.

In einem weiteren Verfahren des Stands der Technik können Kleinteile durch Strömung vereinzelt und/oder sortiert werden. Hierbei wird ein Behälter, der mit Öffnungen versehen ist, mit Wasser gefüllt. Es werden die Bauelemente, die sortiert werden sollen, in die Flüssigkeit eingebracht. Wird die Flüssigkeit durch Öffnungen angesaugt, bewegen sich die Bauelemente mit der Strömung und legen sich auf bzw. in definiert angeordnete Auslassöffnungen. Die Teile können dann gezielt von dort herausgenommen werden. Ein solches Verfahren ist z.B. in Lenders, C., Valsamis, J., Desaedeleer, M., Delchambre, A., Lambert, P.: "Assembly of a Micro Ball-Bearing using a Capillary Gripper and a Microcomponent Feeder", IPAS(2008)265-274 beschrieben.

Ein weiteres gängiges Verfahren zum Vereinzeln und sortieren von Kleinteilen ist das Sieben.

Ein weiteres Verfahren ist aus dem Dokument US 2010/0266769 bekannt.

Die Verfahren des Standes der Technik haben eine Reihe von Nachteilen. So erfahren die Kleinteile bei typischerweise direktem Kontakt untereinander und zur Vorrichtung (fehlende Dämpfung) durch eine Vibration große Beschleunigungen und stoßen gegeneinander oder reiben aneinander, was zu Beschädigung und Verschmutzung führen kann. Darüber hinaus ist der Vorgang der Vibration bei kleinsten Bauteilen mit geringer Masse nur schwer beherrschbar. Bauteile mit großen Aspektverhältnissen und/oder sich verhakenden Strukturen lassen sich nur begrenzt oder gar nicht separieren. Durch die typischerweise auftretende Reibung können sich die Bauteile elektrostatisch aufladen und dadurch aneinander oder an umgebenden Strukturen anhaften. Mit den Lösungen des Stands der Technik können typischerweise nur Bauteile größer als 0,5 mm bearbeitet werden.

Aufgabe der vorliegenden Erfindung ist es, die Nachteile des Stands der Technik zu überwinden.

Die Aufgabe wird gelöst durch das Verfahren zum Anordnen von Kleinteilen nach Anspruch 1 und die Vorrichtung zum Anordnen von Kleinteilen nach Anspruch 12. Die jeweiligen abhängigen Ansprüche geben vorteilhafte Ausgestaltungen des erfindungsgemäßen Verfahrens und der erfindungsgemäßen Vorrichtung an.

Erfindungsgemäß wird ein Verfahren zum Anordnen von Kleinteilen angegeben, wobei ein Flüssigkeitsvolumen mit zumindest einer zumindest bereichsweise gekrümmten Oberfläche angelegt wird. Vorzugsweise ist die Oberfläche vollständig gekrümmt. Die Krümmung der Oberfläche ist normalerweise eine Folge der Oberflächenspannung der Flüssigkeit. Die verwendete Flüssigkeit kann abhängig von den anzuordnenden Kleinteilen so gewählt werden, dass sie eine geeignete Oberflächenspannung aufweist, die bei den vorgesehenen Geometrien in der Lage ist, die Kleinteile zu tragen oder eine solche Dichte aufweist, dass die Kleinteile auf der Flüssigkeit schwimmen.

Es wird nun die Vielzahl der anzuordnenden Kleinteile, d.h. zumindest zwei der anzuordnenden Kleinteile, auf zumindest einen gekrümmten Bereich der Oberfläche aufgebracht. Die Kleinteile werden dann nach dem Aufbringen aufgrund der Oberflächenspannung und/oder dem Auftrieb von der Oberfläche der Flüssigkeit bzw. der Flüssigkeit getragen. Die Kleinteile können hierbei beispielsweise durch Fallenlassen aus geringer Höhe auf die Oberfläche der ruhenden Flüssigkeit aufgebracht werden. Die Teile werden dabei so auf die gekrümmte Oberfläche der Flüssigkeit aufgebracht, dass sie sich in Folge der Krümmung der Oberfläche in eine Zwischenposition bewegen. Die Bewegung der Kleinteile wird dabei normalerweise durch die Wirkung der Schwerkraft bewirkt. Wirkt also die Schwerkraft auf die sich auf der gekrümmten Oberfläche befindenden Kleinteile, so rutschen diese bis zu einem Minimum bzw. tiefsten Punkt der Flüssigkeitsoberfläche oder soweit, bis sie gegen eine Barriere stoßen. Die Zwischenposition lässt sich auf verschiedene Weise verstehen. Zum einen bewegt sich jedes Kleinteil in jeweils eine bestimmte Position, die als jeweilige Zwischenposition des Kleinteils angesehen werden kann. Zum anderen kann sich an einem oder mehreren Orten eine Anhäufung von Kleinteilen nach dem Rutschen auf der gekrümmten Oberfläche bilden. Dieser Ort kann ebenfalls als Zwischenposition bezeichnet werden.

Aufgrund der umgebenden Flüssigkeit sind die Kleinteile gegenüber Beschädigungen durch Stöße geschützt.

Erfindungsgemäß werden die Kleinteile, nachdem sie sich in die Zwischenposition bewegt haben, mit einer Vibration beaufschlagt bzw. in Schwingung gebracht. Die Beaufschlagung mit der Vibration oder Schwingung kann beispielsweise durch Strömungsimpulse im Medium oder durch Luftstöße auf der Oberfläche erfolgen. Auch andere Verfahren sind möglich. Die Schwingung oder Vibration kann beispielsweise mittels eines Schallgebers, eines Vibrationselementes oder einer gepulsten Luftdüse erzeugt werden.

Durch diese Schwingungen werden die Kleinteile in die Anordnungsposition überführt, in der sie dann angeordnet vorliegen. Auch die Anordnungsposition kann als jeweils eine individuelle Anordnungsposition für jedes Kleinteil angesehen werden oder als eine gemeinsame Anordnungsposition, in der die Kleinteile gemeinsam angeordnet vorliegen. Im letzteren Fall könnte man auch von einem Anordnungsbereich sprechen.

Die Kleinteile können hier vorteilhafterweise beispielsweise entlang einer Linie aufgereiht vorliegen. Dabei können sie sich berühren oder einen Abstand voneinander haben. Die Kleinteile können insbesondere auch entlang einer Geraden oder eines Kreises aufgereiht vorliegen. Wie die Kleinteile in der Anordnungsposition angeordnet werden, kann sich durch die Geometrie des Flüssigkeitsvolumens und/oder einer dieses begrenzenden Geometrie ergeben. Möglichkeiten hierfür werden im folgenden ausgeführt. Die Anordnung kann unter anderem durch die Form des Randes des Flüssigkeitsvolumens bestimmt werden.

Insbesondere können die Kleinteile bei beispielsweise konvexen Oberflächen auf der Oberfläche des Flüssigkeitsvolumens zunächst an dessen Rand rutschen. Die Zwischenposition liegt dann also am Rand des Flüssigkeitsvolumens vor. Durch die Vibration ordnen sich die Kleinteile dann entlang des Randes an. Ist also der Rand gerade, so liegen die Kleinteile in diesem Fall entlang einer Geraden vor. Ist der Rand gekrümmt, so liegen die Kleinteile entlang einer gekrümmten Linie vor.

Das erfindungsgemäße Anordnen der Kleinteile kann zu einer Vereinzelung der Kleinteile führen. Erfindungsgemäß können daher auch ein Verfahren und eine Vorrichtung zum Vereinzeln von Kleinteilen sein. Auch kann mit dem Anordnen der Kleinteile eine Positionierung und/oder ein Ordnen der Kleinteile einhergehen. Erfindungsgemäß können daher auch ein Verfahren und eine Vorrichtung zum Positionieren und/oder zum Ordnen von Kleinteilen sein.

Das Flüssigkeitsvolumen kann auf verschiedene Weise angelegt werden. Zum einen ist es möglich, das Flüssigkeitsvolumen auf einer ebenen Oberfläche anzulegen, so dass ein Rand des Flüssigkeitsvolumens in der Ebene der Oberfläche bzw. auf der Oberfläche verläuft. In diesem Fall kann die Oberflächenspannung der Flüssigkeit ein bestimmtes Flüssigkeitsvolumen auf der Oberfläche zusammenhalten, ohne dass das Flüssigkeitsvolumen zerfließt. Die Oberfläche, auf der das Flüssigkeitsvolumen angelegt wird, kann auch in Richtung des Flüssigkeitsvolumens oder von dem Flüssigkeitsvolumen weg gekrümmt sein, wobei der Rand des Flüssigkeitsvolumens ebenfalls auf der Oberfläche verläuft.

Wird ein Flüssigkeitsvolumen in beschriebener Weise auf einer Oberfläche so angelegt, dass der Rand des Flüssigkeitsvolumens auf der Oberfläche verläuft, so ist die Oberfläche des Flüssigkeitsvolumens in der Regel konvex. Werden nun auf das Flüssigkeitsvolumen, beispielsweise am höchsten Punkt des Flüssigkeitsvolumens, also den Bereich maximaler Entfernung von der Oberfläche, Kleinteile aufgebracht, so bewegen sich diese unter Einwirkung der Schwerkraft bis zum Rand des Flüssigkeitsvolumens, wo sie dann in der Zwischenposition vorliegen.

Es ist möglich, das Flüssigkeitsvolumen auf der Oberfläche zu formen, indem auf der Oberfläche zumindest ein hydrophiler Bereich und zumindest ein hydrophober Bereich ausgebildet werden. Wird nun Flüssigkeit für das Flüssigkeitsvolumen auf den hydrophilen Bereich aufgetragen, so zerfließt diese im hydrophilen Bereich so weit, bis sie auf den hydrophoben Bereich trifft. Weiteres Hinzufügen von Flüssigkeit führt zu einem Flüssigkeitsvolumen, das auf dem hydrophilen Bereich der Oberfläche vorliegt und durch den hydrophoben Bereich begrenzt wird. Dabei ergibt sich im Grenzbereich ein Kontaktwinkel (auch Randwinkel oder Benetzungswinkel), der den Winkel bezeichnet, den das Flüssigkeitsvolumen auf der Oberfläche zu dieser Oberfläche bildet. Flüssigkeit kann solange hinzugefügt werden, bis der auf die Anwendung angepasste Kontaktwinkel erreicht ist. Vorteilhafterweise umgibt dabei der hydrophobe Bereich den hydrophilen Bereich in zumindest einer Richtung und umgibt ihn besonders bevorzugt vollständig. Die Erzeugung eines Flüssigkeitsvolumens mit definiertem Kontaktwinkel ist auch möglich, durch das Auftragen eines Flüssigkeitstropfen auf eine hinsichtlich der Benetzbarkeit modifizierten Oberfläche.

In einer vorteilhaften Ausgestaltung der Erfindung kann das Flüssigkeitsvolumen in einer Kavität angelegt werden. Eine solche Kavität kann als Rinne oder auch topfförmig jeweils mit unterschiedlichen, den Erfordernissen angepassten Umrissen ausgestaltet sein. In entsprechender Weise kann auch das Flüssigkeitsvolumen in einer durch zumindest zwei Flächen begrenzten Ecke ausgebildet sein. Bevorzugt hat dabei eine Fläche, bevorzugt die untere, eine hydrophile/hydrophobe Grenze. Im Folgenden wird unter einer Kavität vorzugsweise eine konkave Struktur verstanden und besonders bevorzugt eine topfförmige Struktur mit einem in Richtung der Schwerkraft unten angeordneten Boden und zumindest einer seitlichen Begrenzung in zwei entgegengesetzte Richtungen. Auch eine Rinne soll daher als Kavität im allgemeinen Sinne angesehen werden.

Bevorzugterweise kann die Kavität in horizontaler Richtung einen rechteckigen, quadratischen, elliptischen oder kreisförmigen Querschnitt aufweisen.

Das Flüssigkeitsvolumen kann so angelegt werden bzw. die Kavität so mit Flüssigkeit gefüllt werden, dass es eine konkave Oberfläche aufweist, die in das Flüssigkeitsvolumen hinein gekrümmt ist. In diesem Falle verläuft vorzugsweise die Oberfläche unterhalb eines Rands der Kavität. Das Flüssigkeitsvolumen kann vorteilhaft auch mit einer konvexen Oberfläche angelegt werden, die sich aus dem Flüssigkeitsvolumen heraus krümmt. In diesem Falle kann sich die Oberfläche zumindest bereichsweise oberhalb eines Rands der Kavität erstrecken.

In einer bevorzugten Ausführungsform der Erfindung wird das Flüssigkeitsvolumen während des Verfahrens verändert. Besonders vorteilhaft kann, nachdem die Kleinteile die Anordnungsposition erreicht haben, Flüssigkeit aus dem Flüssigkeitsvolumen abgeführt und/oder abgesaugt werden. Hierdurch verändert sich die Oberfläche, was zur Vereinzelung und/oder Ordnung der Kleinteile ausgenutzt werden kann. Besonders vorteilhaft wird die Flüssigkeit aus dem Flüssigkeitsvolumen abgeführt und/oder abgesaugt, bis sich zumindest eines, vorzugsweise alle Kleinteile auf zumindest einer Ablagefläche ablegen. Vorteilhaft ist hierbei zu Beginn die Oberfläche der Flüssigkeit so geformt, dass sich die Kleinteile vom Ort ihres Aufbringens auf die Flüssigkeitsoberfläche unter dem Einfluss der Schwerkraft in die Zwischenposition und durch Vibration in die Anordnungsposition bewegen und bei Abführen bzw. Absaugen der Flüssigkeit aus dem Flüssigkeitsvolumen sich auf die vorgesehenen Ablageflächen ablegen.

Weist das Flüssigkeitsvolumen eine konvexe Oberfläche auf, so sind die Ablageflächen vorzugsweise an einem Rand der Kavität ausgebildet. Wird das Flüssigkeitsvolumen auf einer Oberfläche angelegt, können auch Ablageflächen auf der Oberfläche am Rand des Flüssigkeitsvolumens ausgebildet sein. In diesen Fällen können sich die Kleinteile auf der konvexen Oberfläche zum Rand des Flüssigkeitsvolumens hin bewegen. Durch die Vibration verteilen sich die Kleinteile über den Bereich in dem die Ablageflächen ausgebildet sind. Wird die Flüssigkeit aus dem Flüssigkeitsvolumen abgeführt bzw. abgepumpt, legen sich die Kleinteile dann auf den Ablageflächen ab. Die Position nach Abführen der Flüssigkeit kann als Ablageposition bezeichnet werden.

Wird das Flüssigkeitsvolumen mit einer konkaven Oberfläche angelegt, können die Ablageflächen vorteilhaft unterhalb eines Minimums der Oberfläche und/oder in einer Mitte der Kavität ausgebildet sein. Das Minimum der konkaven Oberfläche ist dabei jener Bereich, der in Wirkrichtung der Schwerkraft am weitesten unten liegt.

Vorteilhafterweise weist die zumindest eine Ablagefläche zumindest eine Barriere zu der Kavität oder einem Ort der Abführung oder Absaugung der Flüssigkeit hin auf. Durch eine solche Barriere kann verhindert werden, dass die Kleinteile zusammen mit der Flüssigkeit abgesaugt werden. Die Barriere kann die Kleinteile zurückhalten, so dass diese sich auf der entsprechenden Ablagefläche ablegen können.

In einer vorteilhaften Ausgestaltung der Erfindung kann die zumindest eine Ablagefläche als nach oben offene Rinne ausgebildet sein. Diese Rinne kann an zwei gegenüberliegenden Rändern begrenzt sein und nach oben zunächst offen sein. Vorteilhafterweise ist diese Rinne dort anlegt, wo sich die Kleinteile nach Absaugen oder Abführen der Flüssigkeit ablegen, also beispielsweise an einem oder mehreren Rändern der Kavität oder des Flüssigkeitsvolumens oder unterhalb des Minimums der Flüssigkeit wie oben beschrieben. Wird nun die Flüssigkeit aus der Kavität abgesaugt oder abgeführt, so können sich die Kleinteile, mit einem Flüssigkeitsrest oder ohne Flüssigkeitsrest, in der Rinne ablegen. Sie können dann aus der Rinne entnommen, abfließen oder abgesaugt werden.. Zum Entnehmen ist es vorteilhaft, wenn kein Flüssigkeitsrest zurückbleibt. Wird die Flüssigkeit mit einer angepassten Geschwindigkeit entfernt, so kann anstelle der Rinne auch eine Stufe zwischen Außenwand der Kavität und der Kavität vorgesehen werden.

In einer vorteilhaften Ausgestaltung kann die Rinne nach dem Absaugen bzw. Abführen der Flüssigkeit abgedeckt werden, so dass sich ein Kanal bzw. ein Tunnel ergibt, in dem die abgelegten Kleinteile vorliegen. Aus diesem Kanal bzw. Tunnel können die Kleinteile dann abgesaugt werden. Es ist tauch möglich, dass die Kleinteile abfließen oder dosiert werden.

In einer besonders vorteilhaften Ausgestaltung der Erfindung können die Ablageflächen einen Umriss aufweisen, der (unter Berücksichtigung eines hinreichenden Toleranzbereiches) dem Umriss der zu vereinzelnden Kleinteile entspricht. Die Ablagefläche kann dabei jeweils als Vertiefung in einer Fläche ausgebildet sein, wobei die Vertiefung einen Umriss aufweist, der (unter Berücksichtigung eines hinreichenden Toleranzbereiches) dem Umriss des entsprechenden Kleinteiles entspricht. Legt sich nun ein Kleinteil in dieser Vertiefung auf der Ablagefläche ab, so liegt sein Umriss bereichsweise oder vollständig an der Wand der Vertiefung an oder verläuft zu diesem parallel.

Vorteilhafterweise kann ein Deckel auf die Ablagefläche aufgebracht werden, mittels dessen die Kleinteile in der entsprechenden Vertiefung festgehalten werden. Die zumindest eine Ablagefläche kann vorteilhaft, nachdem die Kleinteile die Anordnungsposition eingenommen haben, mit dem Deckel so abgedeckt werde, dass die Kleinteile nicht aus der Vertiefung der entsprechenden Ablagefläche entweichen können.

Besonders bevorzugt ist es, wenn dabei die Kleinteile frei beweglich in der Vertiefung sind und außerdem umspülbar sind, die entsprechende Vertiefung aber nicht verlassen können. Hierdurch wird es möglich, die Kleinteile mit speziellen Prozessflüssigkeiten und/oder Gasen, Plasma oder Reaktionslösungen in Kontakt zu bringen um sie beispielsweise zu reinigen, wenn die entsprechende Flüssigkeit ein Lösemittel ist, zu aktivieren, vorzubehandeln oder zu umspülen um sie dadurch in der Vertiefung auf der Ablagefläche weiter zu verarbeiten.

Der Deckel und/oder die Ablageflächen können vorteilhaft zumindest einen Kanal aufweisen, über welchen eine Flüssigkeit und/oder ein Gas zu den in den Vertiefungen der Ablageflächen angeordneten Kleinteile geleitet wird und/oder über welchen ein Vakuum an Kleinteile angelegt wird, mittels welchem die Kleinteile auf den Ablageflächen festgehalten werden.

Bevorzugt kann die Ablagefläche (9) so mit dem Deckel abgedeckt werden, dass ein Austausch von Gas und/oder Flüssigkeit an einem Rand des Deckels vorbei zwischen der Vertiefung einer Umgebung stattfinden kann.

Die Zuführung von Prozessflüssigkeiten und/oder-Gasen kann durch separate Kanäle zu den einzelnen Vertiefungen oder über einen gemeinsamen Versorgungskanal erfolgen. Es ist aber auch möglich, die mit dem Deckel verschlossene Ablagefläche in ein Bad einzutauchen.

Die genannten Kanäle können im Deckel und/oder in der Ablagefläche eingebracht sein.

Es ist auch möglich, nach der Behandlung mit der Prozessflüssigkeit oder dem Prozessgas die einzelnen Kanäle mit einem Vakuum zu beaufschlagen um restliche Flüssigkeit oder Gas abzusaugen. Darüber hinaus können vorteilhaft mittels eines Vakuums auch die Kleinteile festgehalten werden. Hierdurch können besonders bevorzugt die Kleinteile auch gleichzeitig getrocknet werden.

Sind die genannten Kanäle im Deckel angeordnet, so kann der Deckel auch als Vakuumgreifer und/oder als Magazin genutzt werden, um beispielsweise die Bauteile in der durch die Vertiefungen bestimmten Lage auf definierten Oberflächen wieder abzulegen und/oder zu montieren.

Darüber hinaus kann vorteilhaft jede Vertiefung mit einem darin befindlichen Kleinteil als Miniatur-Reaktionskammer für biologische, chemische, biochemische oder physikalische Prozesse auf den Kleinteilen verwendet werden.

Beispielsweise können durch Zuführen beispielsweise eines Ätzmediums und Ausgestaltung des Deckels sowie der Ablagefläche mit den Vertiefungen aus einem Material, welches durch das Ätzmedium nicht angegriffen wird, die Bauteile in einem vereinzelten Zustand strukturiert und verarbeitet werden. So ist es beispielsweise möglich, für Forschungen im Labor in jede Mikro-Reaktionskammer unterschiedliche Prozessflüssigkeiten und/oder-Gase einzuführen. Hierdurch ist es möglich, optimale Mischungsverhältnisse oder Konzentrationsverhältnisse, beispielsweise für ein späteres Produkt an mehreren Versuchsproben parallel bestimmen zu können.

Beispielsweise können um die ideale Haftfestigkeit einer Beschichtung zu bestimmen, für jedes Bauteil unterschiedliche Parameter und Varianten der Prozessflüssigkeiten und/oder-Gase zugeführt werden und diese dadurch in einem frühen und miniaturisierten Maßstab untersucht und erprobt werden. Im biologischen Bereich können beispielsweise für Implantate in die Vertiefungen Versuchsproben mit unterschiedlichen Beschichtung und/oder Rauhigkeiten abgelegt werden und durch anschließendes Zuführen einer mit Bakterien versetzten Nährlösung in die Vertiefungen das Vermehrungsverhalten der Bakterien auf den Proben parallel im miniaturisierten Maßstab und/oder mit originalen Bauteilen untersucht werden.

In einer vorteilhaften Ausgestaltung der Erfindung kann die Vibration zur Gruppierung und/oder Vereinzelung der Kleinteile verwendet werden. Es kann hierbei die Vibration so eingebracht werden und das Flüssigkeitsvolumen so ausgestaltet werden, dass sich in der Flüssigkeit eine stehende Welle ausbildet. Die Kleinteile lagern sich dann in den Minima der Welle ab. Sie werden dadurch in den Minima der Welle gruppiert. Die Anzahl der Teilchen in einer Gruppe kann durch die Wellenlänge der stehenden Welle beeinflusst werden. Je länger die Wellenlänge ist, desto mehr Kleinteile können sich in einem Minimum ablagern. Bei hinreichend kurzer Wellenlänge kann jede Gruppe nur ein Kleinteil umfassen, so dass in diesem Fall die Kleinteile vereinzelt werden. Der genaue Wert der erforderlichen Wellenlänge hängt von der Abmessung der Kleinteile ab.

Über der Oberfläche des Flüssigkeitsvolumens befindet sich im Normalfall die Umgebungsatmosphäre. Es ist aber auch möglich, diese Oberfläche in einem anderen Gas oder einer anderen Flüssigkeit, auszubilden, die mit der Flüssigkeit des Flüssigkeitsvolumens eine Grenzfläche bildet.

Das erfindungsgemäße Verfahren ist besonders vorteilhaft für Kleinteile einsetzbar, die eine maximale Kantenlänge kleiner oder gleich 1 mm, vorzugsweise kleiner oder gleich 750 µm und besonders bevorzugt kleiner oder gleich 500 µm haben. Vorzugsweise sind die Kleinteile gefertigte Teile, die nicht natürlich vorkommende Teile sind. Die Kleinteile können verschiedenste Geometrien aufweisen. Insbesondere können sie flächig, plattenförmig oder scheibenförmig mit unterschiedlichen Umrissen ausgebildet sein oder auch länglich. Die Kleinteile können beispielsweise einen kreisförmigen, elliptischen, rechteckigen, quadratischen, dreieckigen oder polygonalen Umriss oder Querschnitt haben. Das Verfahren ist auch für reibungs- oder kontaminationsempfindliche Teile wie z.B. optische Komponenten oder beschichtete Teile anwendbar.

Insbesondere kann das erfindungsgemäße Verfahren auch auf längliche Körper mit einem Querschnitt senkrecht zur Längsrichtung von kleiner oder gleich 1 mm, vorzugsweise kleiner oder gleich 750 µm und besonders bevorzugt kleiner oder gleich 500 µm und beliebiger Länge Anwendung finden, also zum Beispiel auf Fäden, Nadeln oder Drähte, insbesondere mikrochirurgische Fäden, Nadeln oder Drähte.

Die Kleinteile können beispielsweise Metall, Kunststoff, Polymere, Keramik, Halbleiter und/oder natürliche Stoffe aufweisen oder daraus bestehen.

Die Kleinteile und die verwendete Flüssigkeit des Flüssigkeitsvolumens werden so aufeinander abgestimmt, dass die Kleinteile, vorzugsweise durch die Oberflächenspannung der Flüssigkeit, auf der Flüssigkeit getragen werden

Die Vereinzelung der Kleinteile kann vorteilhaft dadurch unterstützt werden, dass die Flüssigkeit mit einer Strömung beaufschlagt wird. Hierzu kann beispielsweise die Kavität als Rinne ausgebildet sein, der die Flüssigkeit zugeführt und/oder abgeführt wird. Werden nun an einem bestimmten Ort die Kleinteile auf die Flüssigkeitsoberfläche gegeben, so werden diese durch die Strömung der Flüssigkeit abtransportiert, so dass zwischen nacheinander aufgebrachten Kleinteilen ein Abstand entsteht.

Erfindungsgemäß wird außerdem eine Vorrichtung zum Anordnen oder zum Vereinzeln oder zum Positionieren von Kleinteilen angegeben. Diese Vorrichtung weist zumindest einen Flüssigkeitsaufnahmebereich auf, in dem ein Flüssigkeitsvolumen anlegbar ist. Darüber hinaus weist die Vorrichtung zumindest einen Flüssigkeitsanschluss auf, über den Flüssigkeit in den zumindest einen Flüssigkeitsaufnahmebereich einbringbar ist und/oder aus ihm ableitbar und/oder absaugbar ist. Außerdem weist die erfindungsgemäße Vorrichtung zumindest eine Ablagefläche auf, auf der Kleinteile in einer Vereinzelungsposition ablegbar sind. Die in der obigen Beschreibung zur Ausgestaltung der Kavität, des Flüssigkeitsvolumens und der Ablagefläche wie auch der Kleinteile gemachten Aussagen gelten auch für die erfindungsgemäße Vorrichtung. Vorteilhaft kann der Flüssigkeitsaufnahmebereich die genannte Kavität sein.

Insbesondere kann vorteilhaft zumindest eine der zumindest einen Ablageflächen an einem oberen Rand der Kavität angeordnet sein. Auch kann vorteilhaft die zumindest eine Ablagefläche in einer Mitte der Kavität angeordnet sein, vorzugsweise auf einem gegenüber einem Boden der Kavität erhöhten Sockel.

Vorteilhafterweise weist die Ablagefläche eine die Ablagefläche in horizontaler Richtung begrenzende Barriere auf, die ein Abfließen der Kleinteile und/oder der Flüssigkeit von der Ablagefläche verhindert. Auch hier kann die Ablagefläche als Rinne bzw. Kanal ausgestaltet sein.

In einer vorteilhaften Ausgestaltung kann die erfindungsgemäße Vorrichtung zumindest einen Deckel aufweisen, mit dem die zumindest eine Ablagefläche über der Barriere abdeckbar ist, so dass die Ablagefläche mit den entsprechenden Barrieren und dem Deckel einen Kanal bildet, aus dem vorzugsweise die Kleinteile absaugbar und/oder dosierbar sind.

Die Vorrichtung kann vorteilhaft einen Deckel aufweisen, mit dem die zumindest eine Ablagefläche so abdeckbar ist, dass die Kleinteile nicht aus der Ablagefläche entweichen können, wobei vorzugsweise der Deckel und/oder die zumindest eine Ablagefläche zumindest einen Kanal aufweist, über den Flüssigkeit und/oder Gas zu den in der oder den Ablageflächen angeordneten Kleinteilen leitbar ist und/über den ein Vakuum an die Kleinteile anlegbar ist, mittels dessen die Kleinteile auf den Ablageflächen festhaltbar sind.

Die zumindest eine Ablagefläche und vorzugsweise auch der Deckel können Teil eines Teileaufnahmemodules sein, wobei eine Seitenwand des Teileaufnahmemodules eine Seitenwand des Flüssigkeitsaufnahmebereiches ist und wobei die zumindest eine Ablagefläche an einer Kante der Seitenwand des Teileaufnahmemodules angeordnet ist, wobei das Teileaufnahmemodul von anderen den Flüssigkeitsaufnahmebereich begrenzenden Seitenwänden trennbar ist.

Vorzugsweise können die Umrisse der Ablageflächen den Umrissen der Kleinteile entsprechende Formen haben, wie dies oben beschreiben wurde.

In einer vorteilhaften Ausgestaltung kann die Ablagefläche so ausgestaltet sein, dass sie als ein Teileaufnahmemodul aus der Vorrichtung entnehmbar ist. Dieses Teileaufnahmemodul kann vorteilhafterweise nach der Anordnung der Teile in der Ablagefläche, vorteilhaft auch nachdem der Deckel aufgebracht wurde, der Vorfindung entnommen werden und dann ein Magazin, eine Prozesskammer oder ähnliches sein. Vor einer erneuten Durchführung des erfindungsgemäßen Verfahrens kann das Teileaufnahmemodul wieder in die Vorrichtung eingesetzt werden. Das Teileaufnahmemodul kann auch als Einwegteil ausgestaltet sein.

Vorteilhafterweise ist die erfindungsgemäße Vorrichtung zur Durchführung des oben beschriebenen erfindungsgemäßen Verfahrens geeignet.

Die Erfindung bietet die folgenden Vorteile gegenüber dem Stand der Technik. Zum einen ist sie für kleinste Teile wie beispielsweise Mikrochips, Zahnräder, Stifte, O-Ringe, Federn, Fasern oder auch Mikrokugeln anwendbar. Es entsteht keine elektrostatische Aufladung der Teile durch das erfindungsgemäße Verfahren. Darüber hinaus bestehen keine Reibung und auch keine starken Stöße zwischen den zu vereinzelnden Kleinteilen. Das erfindungsgemäße Verfahren und die erfindungsgemäße Vorrichtung sind einerseits universell für unterschiedliche Teile auslegbar als auch applikationsspezifisch für vorgegebene Teile. Die Vorrichtung ist einfach und kostengünstig realisierbar. Die Fluidikeinheit ist auch als Einweg umsetzbar. Die Erfindung ermöglicht eine einfache Handhabung. Die fluidtechnische Nutzfläche ist frei skalierbar. Die Erfindung erlaubt es außerdem, Kleinteile in einer Reihe mit definiertem Abstand und/oder in definierter Position anzuordnen. Hier ist insbesondere die oben beschriebene Ausführung mit einer durch die Vibration bewirkten stehenden Welle vorteilhaft.

Im Folgenden soll die Erfindung unter Bezugnahme auf einige Figuren beispielhaft erläutert werden.

Es zeigt
- Fig. 1: eine erfindungsgemäße Anordnung durch Vereinzelung von Kleinteilen auf drei unterschiedlichen Flüssigkeitsoberflächen,
- Fig. 2: eine erfindungsgemäße Vorrichtung, mit der das erfindungsgemäße Verfahren durchführbar ist,
- Fig. 3: eine weitere beispielhafte erfindungsgemäße Vorrichtung, mit der das erfindungsgemäße Verfahren durchführbar ist,
- Fig. 4: eine erfindungsgemäße Vorrichtung mit einer Abdeckung.
- Fig. 5: beispielhaft eine als Teileaufnahmemodul ausgestaltete Ablagefläche mit darauf aufgesetztem Deckel, und
- Fig.6: einen Vorgang im erfindungsgemäßen Verfahren, bei welchem eine Ablagefläche als Teileaufnahmemodul aus der Vorrichtung entnommen wird.

Im Folgenden soll zunächst das erfindungsgemäße Verfahren beispielhaft ausgeführt werden. Durch die Erfindung wird es möglich, Kleinstbauteile, wie beispielsweise Halbleiterchips, mit einer Kantenlänge von kleiner als 500 µm oder sogar 300 µm oder andere mikrotechnische bzw. feinwerktechnische Bauteile, die mit konventioneller Technik nur bedingt bzw. nicht verarbeitet werden können, schonend und zuverlässig zu vereinzeln und in definiertem Zustand zur weiteren Verarbeitung bereitzustellen und/oder anzuordnen.

Grundlage der Erfindung bildet der physikalische Effekt, dass leichte Bauteile aufgrund der Oberflächenspannung einer Flüssigkeit und/oder dem Auftrieb nicht untergehen bzw. auf der Oberfläche schwimmen. Weist die Flüssigkeitsoberfläche eine Neigung bzw. Wölbung auf, gleitet ein aufliegendes Bauteil auf dieser hinunter.

Die Erfindung sieht die gezielte Anwendung dieses Effekts bei einer definierten Einstellung der Oberflächenform und -spannung vor. Hinzu kann eine gezielte Variation des verwendeten Flüssigkeitsvolumens kombiniert mit bauteilangepassten, geometrischen Vorkehrungen im Randbereich des Flüssigkeitsvolumens kommen.

Ein Teilaspekt der Erfindung betrifft die Erzeugung des Flüssigkeitsvolumens mit definierter Oberflächenform und Oberflächenspannung. Die Einstellung einer konvexen bzw. konkaven Oberflächengeometrie kann über das Auftragen bzw. Einfüllen eines definierten Flüssigkeitsvolumens auf eine geometrisch bestimmte Benetzungsfläche auf einem Substrat oder in eine in einem Füllvolumen definierte Kavität erfolgen. Die Begrenzung kann unter anderem über eine gezielte Oberflächeneinteilung in hydrophobe und hydrophile Bereiche oder durch die Herstellung geeigneter Oberflächenstrukturen, wie zum Beispiel einer dreidimensionalen Wannenstruktur erfolgen. Möglich sind beispielsweise kreisförmige, ellipsenförmige oder eckige Grundflächen (z.B. Rechteck). Die Auswahl der Flüssigkeit kann auf die Geometrie und das Gewicht des Bauteils (Kleinteils) abgestimmt erfolgen. Der Kontaktwinkel kann dabei die Randbedingungen festlegen und die Oberflächengeometrie vorgeben. Unter dem Kontaktwinkel wird jener Winkel verstanden, den die Oberfläche des Flüssigkeitsvolumens mit der sie begrenzenden Wand bildet. Die Größe des Kontaktwinkels zwischen Flüssigkeit und Wand hängt von der Wechselwirkung zwischen den Stoffen an der Berührungsfläche ab.

Vorteilhafterweise wird das Flüssigkeitsvolumen so ausgelegt, dass auf die Flüssigkeitsoberfläche an beliebiger Stelle aufgebrachte Bauteile bis zu einer Kante des Flüssigkeitsvolumens hinunter gleiten und sich dort in einer Zwischenposition ablegen. Eine Ansammlung mehrerer Bauteile in dieser Zwischenposition wird dann durch Vibration aufgehoben, wobei sich die Kleinteile in eine Anordnungsposition begeben. Im Ergebnis liegen die Kleinteile angeordnet vor und können insbesondere entlang der Fluidkante angeordnet liegen. Vorteilhaft können die Kleinteile durch Abführen der Flüssigkeit in einer Ablageposition abgelegt werden.

Die Anordnung und eine eventuelle Ablage kann vorteilhaft gesteuert werden durch eine Variation des verwendeten Flüssigkeitsvolumens, kombiniert mit bauteilangepassten, geometrischen Vorkehrungen im Randbereich des Flüssigkeitsvolumens. Hierbei kann ein Ein- bzw. Auslass vorgesehen sein, über den beispielsweise mittels einer Pumpe das Flüssigkeitsvolumen definiert dosiert bzw. abgepumpt oder abgeführt werden kann. Die Vorrichtung kann außerdem im Bereich der Fluidkante eine mechanisch und/oder physikalisch auf die Kleinteile wirkende Barriere aufweisen. Diese kann an die Bauteilgeometrie angepasst ausgelegt sein.

Durch eine gezielte Reduzierung des Flüssigkeitsvolumens, beispielsweise durch Abpumpen, kann sich der Randwinkel verringern. Mit kleiner werdendem Randwinkel verringert sich normalerweise auch der Kippwinkel der entlang der Fluidkante auf der Flüssigkeitsoberfläche schwimmenden bzw. aufliegenden Bauteile. Ab einem bestimmten Flüssigkeitsvolumen ist der Kippwinkel minimal und die Bauteile können auf einem dünnen Flüssigkeitsfilm aufliegen. Eine weitere Reduzierung des Flüssigkeitsvolumens kann dann dazu führen, dass sich die Flüssigkeitskante zur Mitte des Flüssigkeitsvolumens bzw. der Kavität zurückzieht. Eine Barriere kann hierbei verhindern, dass die Bauteile mitgezogen werden. Eine solche Barriere kann beispielsweise eine mechanisch wirkenden Anschlagskante oder aber auch eine durch physikalische Oberflächenkräfte auf die Bauteile einwirkende Ablagefläche sein.

Als Ergebnis können alle aufgebrachten Teile hintereinander entlang der Kante bzw. innerhalb der offenen oder geschlossenen Kanalstruktur angeordnet vorliegen. Je nach Auslegung können die Bauteile trocken liegen oder weiterhin von stehender Flüssigkeit umgeben sein, wenn die Barriere einen Teil der Flüssigkeit zurückhält.

Durch eine zusätzliche Strukturierung einer Kante der Kavität, wie beispielsweise teilespezifische Einkerbungen, kann der Abstand der aufgereihten Teile eingestellt und somit ein höherer Ordnungsgrad bzw. eine definierte Entnahmeposition erreicht werden.

Entsprechendes kann auch bei einem konkaven Flüssigkeitsquerschnitt erreicht werden, bei dem sich die Bauteile beispielsweise im unteren Scheitelpunkt ansammeln können und beim gezielten Ablassen der Flüssigkeit sich in einer innenliegenden Kanalstruktur ablegen können.

Für eine weitere Verarbeitung der aufgereihten Teile kann die Vorrichtung mit angepassten Formelementen erweitert werden, durch deren Anwendung sich beispielsweise ein geschlossener Kanal bildet. Ein solches Element kann beispielsweise eine Abdeckung sein.

Durch das Anbringen eines solchen Formelements, wie beispielsweise einer Abdeckung, kann der Kanal, der durch die Ablagefläche und die Barriere gebildet wird, mit dem darin aufgereihten Kleinteilen abgedeckt werden. Mit einer Flüssigkeit, einem Stift oder auch mittels Druckluft können dann die hintereinander liegenden Teile fluidtechnisch, hydraulisch, pneumatisch oder mechanisch in Richtung des Kanalausgangs gefördert werden und am Kanalausgang einzeln abgegeben bzw. bereitgestellt werden. Eine solche Förderung ist auch ohne eine Abdeckung möglich. Insbesondere können die Kleinteile in einem angrenzenden Kanal weitertransportiert werden.

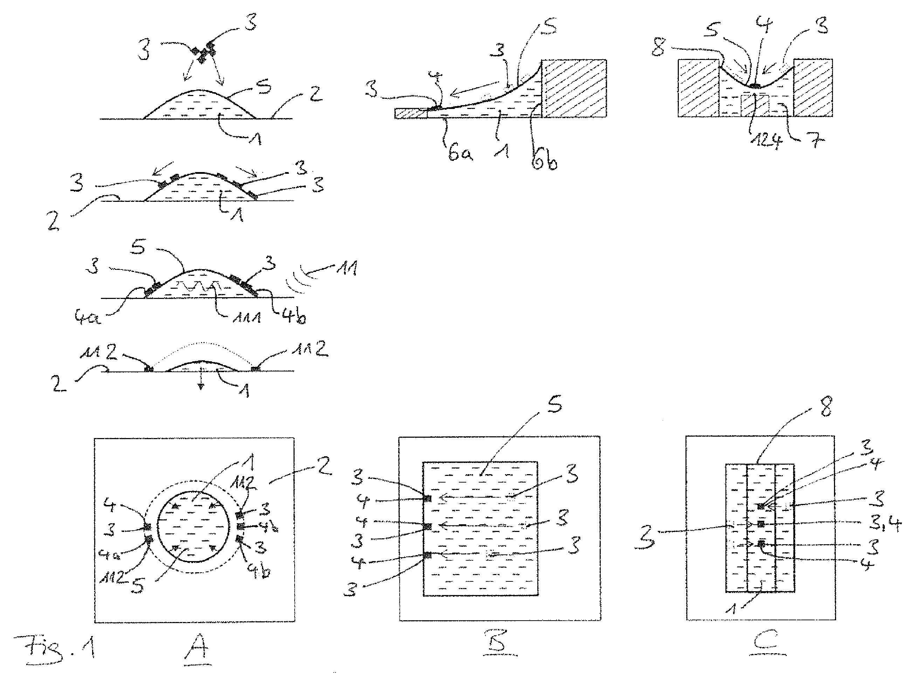

Fig. 1 zeigt in den Teilfiguren 1A, 1B und 1C jeweils in einer Seitenansicht und einer Aufsicht drei beispielhafte Formen eines Flüssigkeitsvolumens 1. In Teilfigur 1A ist das Flüssigkeitsvolumen 1 auf einer ebenen Oberfläche 2 als Tropfen ausgebildet. Es weist daher eine konvexe Oberfläche auf. Werden auf diese konvexe Oberfläche Kleinteile 3 aufgebracht, so werden diese aufgrund der Oberflächenspannung und/oder des Auftriebs von dem Flüssigkeitsvolumen an dessen Oberfläche 5 getragen und rutschen durch die Einwirkung der Schwerkraft zu einem Rand bzw. einer Kante des Flüssigkeitsvolumens 1 in Zwischenpositionen 4a und 4b am Rand des Flüssigkeitsvolumens 1. Dies ist in der zweiten und dritten Zeile der Figur 1A gezeigt. Die Zwischenpositionen 4a und 4b können auch gemeinsam als eine Zwischenposition der Teile angesehen werden, also als eine kollektive Zwischenposition 4. Durch Einwirkung einer Schwingung oder Vibration 111 können die Kleinteile 3 entlang des Randes hinter- bzw. nebeneinander angeordnet werden. Dies ist im untersten Teilbild von Figur 1A zu erkennen. Liegen an den Positionen 4a und 4b Anhäufungen von Kleinteilen vor, wie in der dritten Zeile der Figur 1A, so werden diese durch die Vibration in die Anordnungsposition 112 überführt. Die Kleinteile sind dann entlang des Randes des Flüssigkeitsvolumens aufgereiht. Wie in der in Figur 1A zu unterst gezeigten Aufsicht zu erkennen, ist der Umfang des Flüssigkeitsvolumens in diesem Beispiel im Wesentlichen kreisförmig. Nachdem die Kleinteile die Anordnungsposition 112 erreicht haben, kann die Flüssigkeit aus dem Flüssigkeitsvolumen abgeführt werden. Dies ist in den beiden untersten Zeilen der Figur 1 durch die gestrichelte Linie angedeutet, die den Rand des Flüssigkeitsvolumens zu einem früheren Zeitpunkt als die durchgezogene Linie zeigt.

Fig. 1B zeigt ein Flüssigkeitsvolumen, das in einer Ecke aus zwei Flächen 6a und 6b ausgebildet ist. Es bildet sich hier durch eine entsprechende Benetzbarkeit der Flächen 8a und 6b eine Oberfläche 5 des Flüssigkeitsvolumens 1 aus, die von der vertikalen Begrenzungsfläche 6b weggeneigt ist. Hierdurch bewegt sich ein auf die Flüssigkeitsoberfläche 5 aufgebrachtes Kleinteil 3 durch die Wirkung der Schwerkraft von der vertikalen Wand 6b weg in die Zwischenposition 4. In der Anordnungsposition liegen die Kleinteile 3 entlang des Randes des Flüssigkeitsvolumens hintereinander, wobei jedoch nur ein Bauteil 3 dargestellt ist. Durch eine Abdeckung 123 kann hier ein Kanal erzeugt werden, aus dem die Kleinteile absaugbar sind. Die Kleinteile können aber auch ohne Abdeckung durch Strömung im Kanal absaugbar sein.

Wie in der in Fig. 1B unten gezeigten Aufsicht zu erkennen ist, wird das Flüssigkeitsvolumen 1 in zur Erstreckungsrichtung der Wand 6a und 6b senkrechter Richtung ebenfalls durch Wände begrenzt, so dass sich ein in horizontaler Richtung rechteckiger Querschnitt des Flüssigkeitsvolumens 1 ergibt. In der in Fig. 1B gezeigten Ausführungsform ist die Oberfläche 5 des Flüssigkeitsvolumens 1 konkav. 3.4

Fig. 1C zeigt eine weitere Ausführungsform der Erfindung, bei der das Flüssigkeitsvolumen 1 in einer Kavität 7 angelegt wird. Die Oberfläche 5 des Flüssigkeitsvolumens 1 liegt hierbei vollständig unterhalb eines Randes 8 der Kavität, da die Flüssigkeitsoberfläche 5 konkav ist. Wird nahe des Randes 8 der Kavität ein Kleinteil 3 auf die Flüssigkeitsoberfläche 5 aufgebracht, so gleitet dieses in die Mitte der Oberfläche 5 in die Zwischenposition 4. Diese liegt gerade im Minimum der Oberfläche 5. Unter diesem Minimum ist im gezeigten Beispiel eine Ablagefläche 124 ausgebildet, die gegenüber einem Boden der Kavität 7 erhöht ist. Wird die Flüssigkeit aus der Kavität 7 abgeführt, so legen sich die Kleinteile auf der Ablagefläche 124 ab.

Im unteren Teil von Fig. 1C ist zu erkennen, dass die Kavität in horizontaler Richtung einen rechteckigen Querschnitt hat. Eine Vielzahl von Kleinteilen, die in der Zwischenposition nach dem Rutschen auf der Flüssigkeitsoberfläche als Anhäufung vorliegen, werden durch die Vibration in die Anordnungsposition überführt, in der sie im in Figur 1 gezeigten Beispiel entlang einer Geraden hintereinander aufgereiht sind.

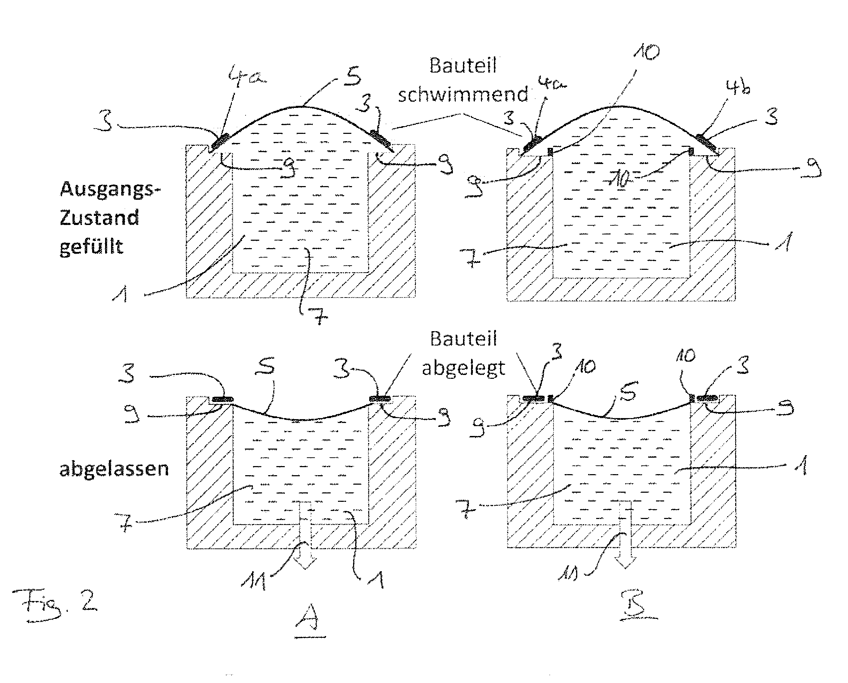

Fig. 2 zeigt in den Teilfiguren 2A und 2B zwei beispielhafte Ausführungsformen der erfindungsgemäßen Vorrichtung, in denen das erfindungsgemäße Verfahren durchführbar ist. In den beiden Teilbildern ist das Flüssigkeitsvolumen 1 in einer Kavität 7 ausgebildet, die in vertikaler Richtung einen rechteckigen Querschnitt hat. Das Flüssigkeitsvolumen wird zunächst, wie in den oberen Teilen der Teilfiguren 2A und 2B gezeigt, mit einer konvexen Oberfläche 5 des Flüssigkeitsvolumens angelegt, die sich oberhalb eines Rands der Kavität 7 erstreckt. Werden auf die Oberfläche 5 hier Kleinteile 3 aufgebracht, so gleiten diese in Zwischenpositionen 4a und 4b. Liegen nun die Kleinteile 3 in den Zwischenpositionen 4a und 4b vor, so werden die Kleinteile 3 anschließend mit einer Vibration beaufschlagt, so dass sie in eine Anordnungsposition übergehen, in der sie entlang des Randes des Flüssigkeitsvolumens in zur Figurenebene senkrechter Richtung hintereinander aufgereiht vorliegen. Es kann anschließend Flüssigkeit aus dem Flüssigkeitsvolumen 1 durch einen Fluiddurchlass 11 abgeführt oder abgesaugt werden. Hierdurch zieht sich die Oberfläche 5 des Flüssigkeitsvolumens zurück. Die Absaugung kann solange erfolgen, bis die Kleinteile 3 auf Ablageflächen 9 zu liegen kommen. Auf den Ablageflächen 9 liegen sie dann jeweils in einer Ablageposition vor. Dies ist in Figur 2A und Figur 2B unten zu erkennen.

In Fig. 2A sind die Ablageflächen unmittelbar am Rand der Kavität 7 ausgebildet und gehen unmittelbar in die Kavität 7 über. Soll verhindert werden, dass die Kleinteile 3 sich bei Absaugen der Flüssigkeit in die Kavität bewegen, so können, wie in Fig. 2B gezeigt, Barrieren 10 vorgesehen sein, die die Ablageflächen 9 gegenüber der Kavität 7 begrenzen und das Bauteil 3 bei Absaugen der Flüssigkeit aus dem Flüssigkeitsvolumen 1 auf der Ablagefläche 9 zurückhalten. Die Barrieren 10 können flüssigkeitsdurchlässig oder flüssigkeitsundurchlässig sein. Sind die flüssigkeitsdurchlässig, so liegen die Bauteile 3 trocken auf den Ablageflächen 9. Sind die Barrieren 10 flüssigkeitsundurchlässig, so liegen die Bauteile 3 in einem Flüssigkeitsfilm auf den Ablageflächen 9.

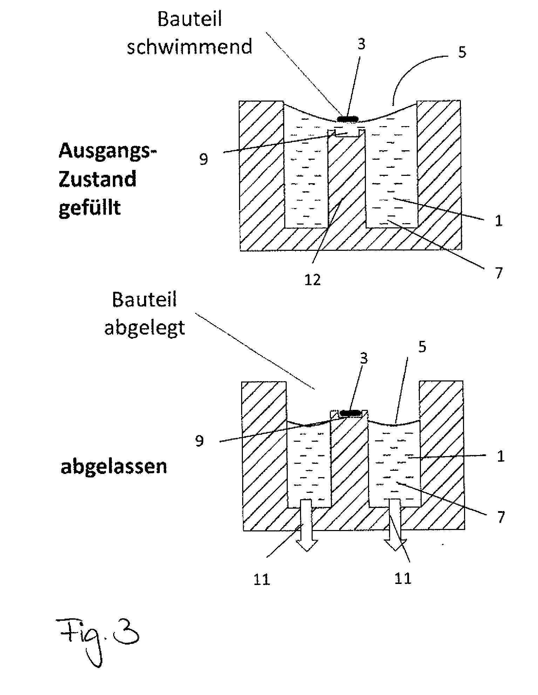

Fig. 3 zeigt in den Teilfiguren 3A und 3B weitere Ausführungsformen der erfindungsgemäßen Vorrichtung, in denen das erfindungsgemäße Verfahren durchführbar ist. In den in Fig. 3A und 3B gezeigten Ausführungsbeispielen wird in der Kavität 7 zunächst ein Flüssigkeitsvolumen 1 mit einer konkaven Oberfläche 5 angelegt, die sich vollständig unterhalb eines Randes der Kavität 7 erstreckt. Wird ein Bauteil 3 auf die Oberfläche 5 des Flüssigkeitsvolumens 1 aufgebracht, so rutscht dieses unter dem Einfluss der Schwerkraft in die Zwischenposition 4, die im gezeigten Beispiel in der Mitte der Kavität 7 liegt. In beiden in Fig. 3 gezeigten Ausführungsformen ist eine Ablagefläche 9 in der Mitte der Kavität angeordnet, also unterhalb der Zwischenposition 4. Es werden dann die Kleinteile mit einer Vibration beaufschlagt, durch welche sie in eine Anordnungsposition bewegt werden. In dieser liegen sie dann über der Ablagefläche 9 hintereinander aufgereiht vor. Wird nun Flüssigkeit durch einen Fluiddurchlass 11 aus der Kavität 7 abgelassen oder abgesaugt, so legt sich das Bauteil 3 in einer Ablageposition auf der Ablagefläche 9 ab. In den beiden Beispielen ist der Fluiddurchlass 11 im Boden der Kavität 7 angeordnet. Er kann aber auch seitlich angeordnet sein. Auch eine Absaugung durch eine Kanüle von oben ist möglich.

In Fig. 3A ist die Ablagefläche 9 eine Vertiefung im Boden der Kavität 7. In Fig. 3B ist die Ablagefläche 9 auf einem Sockel 12 ausgebildet, der sich vom Boden der Kavität 7 aus senkrecht nach oben erstreckt. Dadurch muss im in Fig. 3B gezeigten Beispiel weniger Fluid aus der Kavität 7 abgelassen werden, bis das Bauteil 3 auf der Ablagefläche 9 aufliegt als im in Fig. 3A gezeigten Beispiel. Durch eine Abdeckung 13 kann die Vertiefung in der Ablagefläche 9 abgedeckt werden, so dass die Vertiefung einen Kanal ausbildet, aus dem die Kleinteile absaugbar sind.

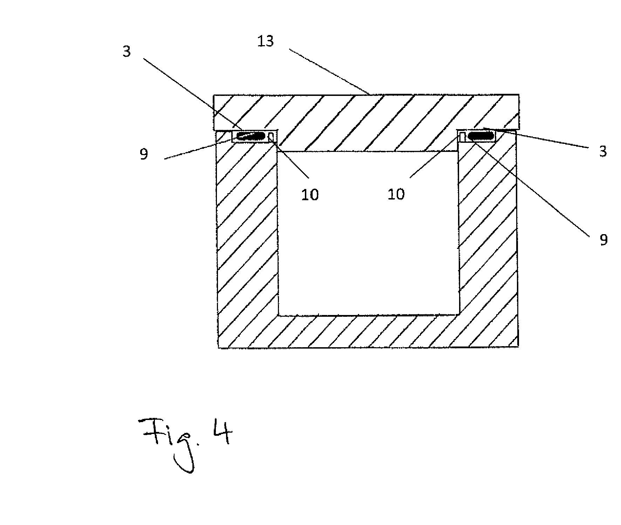

Fig. 4 zeigt schließlich die in Fig. 2B gezeigte Ausführungsform der Erfindung in einem Zustand, nach dem das Fluid vollständig aus dem Flüssigkeitsvolumen 1 und der Kavität 7 abgeführt oder abgesaugt wurde, und die Bauteile 3 auf den Ablageflächen 9 hinter den Barrieren 10 zu liegen gekommen sind. In Fig. 4 ist nun die Vorrichtung durch eine Abdeckung 13 abgedeckt. Diese Abdeckung 13 überstreckt sich über die gesamte horizontale Abmessung der Vorrichtung und deckt insbesondere die Auflageflächen 9 vollständig ab. Die Auflageflächen 9 bilden daher zusammen mit den Barrieren 10 und der Wand der Kavität 7 zwei entlang des Rands der Kavität verlaufende Kanäle, in denen die Kleinteile 3 vorliegen. Die Kleinteile können dann wie oben beschrieben beispielsweise pneumatisch, hydraulisch und/oder mechanisch aus den Kanälen abgeführt werden und an deren Ausgang vereinzelt aufgenommen werden.

Die erfindungsgemäße Vorrichtung ist für den Betrieb im Labor aber auch für die Serienfertigung geeignet. Die Vorrichtung ist einfach aufgebaut und kostengünstig in unterschiedlichen Materialien und mit unterschiedlichen Verfahren herstellbar.

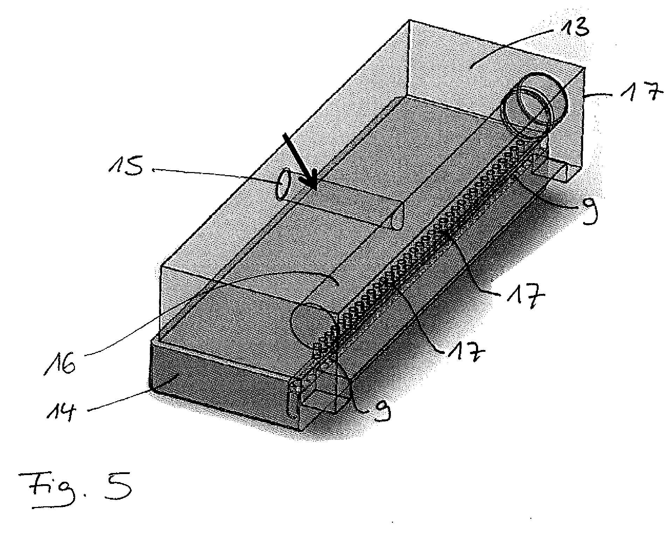

Figur 5 zeigt ein Teileaufnahmemodul aufweisend ein Ablageelement 14 mit den Ablageflächen 9 sowie einem darauf angeordneten Deckel 13.

Die Ablageflächen 9 sind hier als Vertiefungen in einer Oberfläche des Ablageelementes 14 ausgestaltet, wobei der Umfang der Vertiefungen jenem der anzuordnenden Kleinteile entspricht. Vorteilhafterweise können dabei die Vertiefungen so ausgestaltet sein, dass die Kleinteile in den Vertiefungen mit einem Spiel liegen, welches eine Umspülung mit einer Flüssigkeit oder Gas ermöglicht. Die Ablageflächen 9, d.h. die Vertiefungen, sind entlang einer Kante des Ablageelementes 14 äquidistant nebeneinander angeordnet. Bei Durchführung des erfindungsgemäßen Verfahrens kommen die Kleinteile in den Ablageflächen 9 zum liegen.

Es wird dann der Deckel 13 aufgebracht, welcher so ausgestaltet ist, dass er die Kleinteile in den Ablageflächen 9 festhält. Der Deckel 13 ist so ausgestaltet, dass er es erlaubt, die Kleinteile in den Ablageflächen 9 mit einem Gas oder einer Flüssigkeit zu kontaktieren. Hierzu kann der Deckel einen Einlass 15 für das Gas oder die Flüssigkeit aufweisen, der in eine Leitung 16 mündet, die parallel verläuft zu jener Kante des Ablageelementes, 14 entlang welcher die Ablageflächen 9 angeordnet sind. Die Ablageflächen 9 sind über jeweils einen Kanal 17 mit der Leitung 16 verbunden. Es ist alternativ auch möglich, dass sich die Einzelkanäle 17 einzeln und unabhängig voneinander nach außen erstrecken. In diesem Fall kann auf einen gemeinsamen Einlass 15 und eine Leitung 16 verzichtet werden.

Wird nun ein Medium, also eine Flüssigkeit oder ein Gas, in den Einlass 15 eingebracht, so fließt dieses über die Leitung 16 und die Kanäle 17 zu den Ablageflächen 9 und kann dort bei Vorhandensein eines hinreichenden Spieles die Kleinteile in den Ablageflächen 9 umströmen oder umspülen.

Vorteilhafterweise kann der Deckel 13 so ausgestaltet sein, dass, wenn er die Vertiefungen der Ablageflächen 9 abdeckt, ein Abstand zwischen dem Deckel 13 und dem Ablageelement 14 an den Ablageflächen 9 besteht, der so bemessen ist, dass die Kleinteile ihn nicht passieren können, das Gas oder die Flüssigkeit jedoch aus den Vertiefungen 9 austreten können. Auf diese Weise können die Ablageflächen 9 mit durch den Einlass 15 eingeleitetem Gas oder Flüssigkeit umströmt werden.

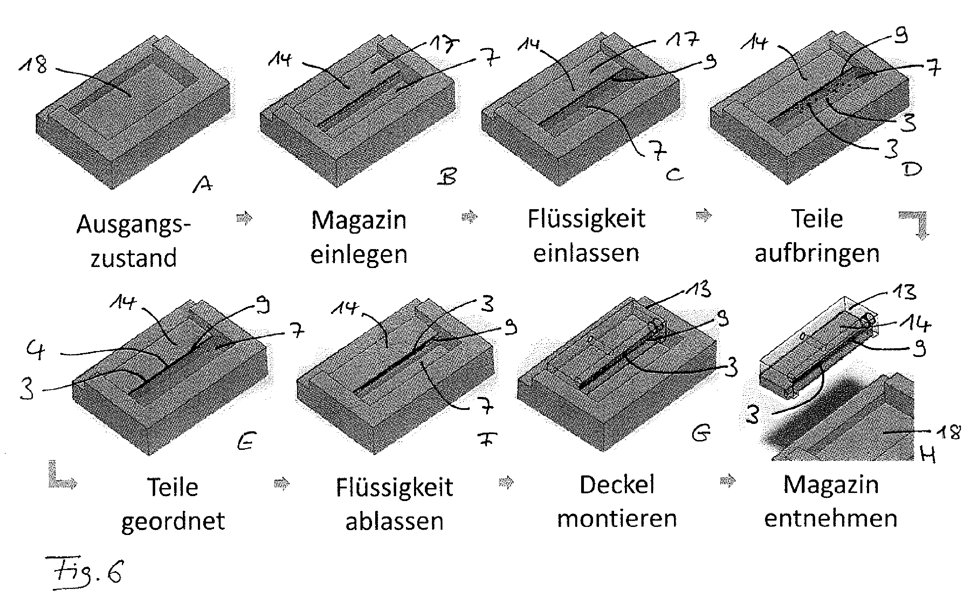

Figur 6 zeigt verschiedene Schritte des Verwendens eines Teileaufnahmemoduls wie es in Fig. 5 gezeigt ist.

Wie in Fig. 6A gezeigt, kann die Vorrichtung zunächst ohne das Teileaufnahmemodul vorliegen. Das Teileaufnahmemodul 17 wird dann in eine Ausnehmung 18 der Vorrichtung eingesetzt, wie dies in Figur 6B gezeigt ist. Es kann dann, wie in Figur 6C gezeigt, Flüssigkeit in eine Kavität 7 eingebracht werden, die gerade jener Bereich der Ausnehmung 18 in der Vorrichtung ist, der nicht vom Modul 17 eingenommen wird. Das Modul 17 bildet hierbei eine die Kavität 7 begrenzende Seitenwand. Das Modul 17 weist an seiner der Kavität 7 zugewandten Kante die Ablageflächen 9 auf, die in Fig. 5 gezeigt sind.

Nachdem nun Flüssigkeit in die Kavität 7 so eingebracht wurde, dass eine konvexe Oberfläche entsteht, können nun, wie in Figur 6D gezeigt, Kleinteile 3 auf die Flüssigkeitsoberfläche aufgebracht werden.

Durch Durchführung des erfindungsgemäßen Verfahrens begeben sich die Kleinteile 3 in ihre Zwischenpositionen, wie in Figur 6E gezeigt. Es kann nun, wie in Figur 6F gezeigt, die Flüssigkeit aus der Kavität 7 abgelassen werden, sodass die Kleinteile 3 in den endgültigen Positionen auf den Ablageflächen 9 zu liegen kommen.

Nach dem Ablassen der Flüssigkeit kann dann, wie in Figur 6G gezeigt, der Deckel 13 auf das Ablageelement 14 aufgebracht werden, so dass dieser die Vertiefungen der Ablageflächen 9 gegen Herausfallen der Kleinteile 3 sichert. Das Magazin kann nun als Ganzes, also mit Ablageelement 14 und Deckel 13, entnommen werden, wodurch die Kleinteile transportiert werden können. Das Teileaufnahmemodul 17 kann nun, also nach Anordnung der Teile, als Magazin, Prozesskammer oder ähnliches genutzt werden.

## Patentansprüche

1. Verfahren zum Anordnen von Kleinteilen, wobei ein Flüssigkeitsvolumen (1) mit zumindest einer, zumindest bereichsweise gekrümmten Flüssigkeitsoberfläche (5) angelegt wird,
und eine Vielzahl von zu vereinzelnden Kleinteilen (3) auf zumindest einen gekrümmten Bereich der Flüssigkeitsoberfläche (5) aufgebracht wird,
wobei die Kleinteile (3) nach dem Aufbringen aufgrund der Oberflächenspannung und/oder dem Auftrieb von der Flüssigkeitsoberfläche (5) getragen werden,
**dadurch gekennzeichnet dass** infolge der Krümmung der Flüssigkeitsoberfläche (5) die Kleinteile (3) sich in eine Zwischenposition (4a, 4b) bewegen,
wobei die Kleinteile (3) in der Zwischenposition (4a, 4b) mit einer Schwingung oder Vibration (111) beaufschlagt werden durch welche sie sich in eine Anordnungsposition (112) begeben.

2. Verfahren nach dem vorhergehenden Anspruch,
wobei das Flüssigkeitsvolumen (1) mit einer konvexen Flüssigkeitsoberfläche (5) auf einer Oberfläche (2), vorzugsweise einer ebenen Oberfläche (2), angelegt wird, so dass ein Rand des Flüssigkeitsvolumens (1) in der Ebene der Oberfläche (2) oder auf der Oberfläche (2) verläuft.

3. Verfahren nach dem vorhergehenden Anspruch,
wobei die Oberfläche (2) zumindest einen hydrophilen Bereich und zumindest einen hydrophoben Bereich aufweist und das Flüssigkeitsvolumen im hydrophilen Bereich angelegt wird und durch den hydrophoben Bereich begrenzt wird.

4. Verfahren nach Anspruch 1, wobei
das Flüssigkeitsvolumen (1) in einer Kavität mit einem Querschnitt angelegt wird, der vorzugsweise in horizontaler Richtung rechteckig, quadratisch, elliptisch oder kreisförmig ist, oder wobei das Flüssigkeitsvolumen in einer Ecke angelegt wird.

5. Verfahren nach dem vorhergehenden Anspruch,
wobei das Flüssigkeitsvolumen (1) mit einer konkaven und sich unterhalb eines Randes der Kavität erstreckenden Flüssigkeitsoberfläche (5) angelegt wird oder
das Flüssigkeitsvolumen (1) mit einer konvexen und sich vorzugsweise zumindest bereichsweise oberhalb eines Randes der Kavität erstreckenden Flüssigkeitsoberfläche (5) angelegt wird.

6. Verfahren nach einem der vorhergehenden Ansprüche,
wobei, nachdem die Kleinteile die Anordnungsposition (112) erreicht haben, Flüssigkeit aus dem Flüssigkeitsvolumen (1) abgeführt und/oder abgesaugt wird bis sich zumindest eines, vorzugsweise alle Kleinteile (3) auf zumindest einer Ablagefläche (9) ablegen.

7. Verfahren nach dem vorhergehenden Anspruch,
wobei das Flüssigkeitsvolumen (1) mit einer konvexen Flüssigkeitsoberfläche (5) angelegt wird und die zumindest eine Ablagefläche (9) an einem Rand der Kavität ausgebildet ist, oder das Flüssigkeitsvolumen (1) mit einer konkaven Flüssigkeitsoberfläche (5) angelegt wird und die Ablagefläche (9) unterhalb eines Minimums der Flüssigkeitsoberfläche (5) und/oder in einer Mitte der Kavität ausgebildet ist,
wobei die zumindest eine Ablagefläche (9) zumindest eine Barriere (10) zu der Kavität oder einem Ort der Abführung oder Absaugung der Flüssigkeit hin aufweist, die für die Flüssigkeit durchlässig ist aber für die Kleinteile (3) undurchlässig und/oder unüberwindbar ist.

8. Verfahren nach einem der Ansprüche 6 oder 7,
wobei die zumindest eine Ablagefläche (9) als nach oben offenen Rinne ausgebildet ist aus der die Kleinteile (3) abgesaugt werden, wobei optional die Rinne nach dem Abführen oder Absaugen der Flüssigkeit aus der Kavität abgedeckt wird, so dass sich ein Kanal bildet, in dem die Kleinteile (3) angeordnet sind, und die Kleinteile (3) nach dem Abdecken aus dem Kanal abgesaugt werden.

9. Verfahren nach einem der Ansprüche 7 oder 8,
wobei die zumindest eine Ablagefläche (9) einen einem Umriss der Kleinteile (3) entsprechenden Umriss aufweist, wobei vorzugsweise die Ablagefläche (9) als Vertiefung mit dem entsprechenden Umriss in einer Fläche ausgebildet ist.

10. Verfahren nach einem der vorhergehenden Ansprüche,
wobei die Flüssigkeit des Flüssigkeitsvolumens (1) während des Aufbringens der Kleinteile (3) mit einer Strömung beaufschlagt wird.

11. Verfahren nach einem der vorhergehenden Ansprüche, wobei durch
die Schwingung oder Vibration (111) auf der Flüssigkeitsoberfläche (5) eine stehende Welle erzeugt wird und die Kleinteile (3) dadurch in Gruppen aufgeteilt oder vereinzelt werden, dass sie in Minima der stehenden Welle rutschen.

12. Anordnungsvorrichtung zum Anordnen von Kleinteilen (3)
mit zumindest einem Flüssigkeitsaufnahmebereich, in dem ein Flüssigkeitsvolumen (1) anlegbar ist,
zumindest einem Flüssigkeitsanschluss (11) über den Flüssigkeit in den zumindest einen Flüssigkeitsaufnahmebereich einbringbar und/oder aus ihm ableitbar und/oder absaugbar ist, sowie mit zumindest einer Ablagefläche (9), auf der Kleinteile (3) in einer Anordnungsposition ablegbar sind, sowie einer Vibrationsvorrichtung (111),
wobei mit der Anordnungsvorrichtung ein Verfahren nach einem der vorhergehenden Ansprüche durchführbar ist.

13. Vorrichtung nach dem vorhergehenden Anspruch, wobei die zumindest eine Ablagefläche (9) als nach oben offene Rinne oder als Vertiefung in einer Fläche mit einem einem Umriss der Kleinteile (3) entsprechenden Umriss der Vertiefung ausgebildet ist.

14. Vorrichtung nach einem der beiden vorhergehenden Ansprüche,
wobei zumindest eine der zumindest einen Ablageflächen (9) an einem oberen Rand des Flüssigkeitsaufnahmebereiches angeordnet ist.

15. Vorrichtung nach Anspruch 13,
wobei die zumindest eine Ablagefläche (9) in eine Mitte des Flüssigkeitsaufnahmebereiches angeordnet ist, vorzugsweise auf einem gegenüber einem Boden des Flüssigkeitsaufnahmebereiches erhöhten Sockel (12).

## Claims

1. Method for arranging small parts, wherein
a liquid volume (1) is created having at least one, at least partially curved liquid surface (5),
and a plurality of small parts (3) to be isolated is applied to at least one curved region of the liquid surface (5),
wherein the small parts (3) are supported after application due to the surface tension and/or buoyancy of the liquid surface (5),
**characterised in that**
as a result of the curvature of the liquid surface (5), the small parts (3) move into an intermediate position (4a, 4b),
wherein the small parts (3) in the intermediate position (4a, 4b) are applied with an oscillation or vibration (111), by means of which they proceed to an arrangement position (112).

2. Method according to the preceding claim,
wherein the liquid volume (1) is created having a convex liquid surface (5) on a surface (2), preferably an even surface (2), such that an edge of the liquid volume (1) runs in the plane of the surface (2) or on the surface (2).

3. Method according to the preceding claim,
wherein the surface (2) has at least one hydrophilic region and at least one hydrophobic region and the liquid volume is created in the hydrophilic region and delimited by the hydrophobic region.

4. Method according to claim 1, wherein
the liquid volume (1) is created in a cavity having a cross section which is preferably rectangular, square, elliptical or circular in the horizontal direction or wherein the liquid volume is created in a corner.

5. Method according to the preceding claim,
wherein the liquid volume (1) is created having a liquid surface (5) which is concave and extends below an edge of the cavity or
the liquid volume (1) is created having a liquid surface (5) which is convex and preferably extends at least partially above an edge of the cavity.

6. Method according to one of the preceding claims,
wherein, after the small parts have reached the arrangement position (112), liquid is guided out and/or siphoned off from the liquid volume (1) until at least one,
preferably all small parts (3) are deposited on at least one depositing surface (9).

7. Method according to the preceding claim,
wherein the liquid volume (1) is created having a convex liquid surface (5) and the at least one depositing surface (9) is formed at an edge of the cavity, or the liquid volume (1) is created having a concave liquid surface (5) and the depositing surface (9) is formed below a minimum of the liquid surface (5) and/or in a centre of the cavity,
wherein the at least one depositing surface (9) has at least one barrier (10) from the cavity or a place for the guiding out or siphoning off the liquid, which is permeable for the liquid but is impermeable and/or insurmountable for the small parts (3).

8. Method according to one of claims 6 or 7,
wherein the at least one depositing surface (9) is formed as an upwardly open channel, from which the small parts (3) are siphoned off, wherein the channel is optionally covered after guiding out or siphoning off the liquid from the cavity such that a duct is formed, in which the small parts (3) are arranged, and the small parts (3) are siphoned out of the duct after covering.

9. Method according to one of claims 7 or 8,
wherein the at least one depositing surface (9) has an outline which corresponds to an outline of the small parts (3), wherein the depositing surface (9) is preferably formed in a surface as an indentation having the corresponding outline.

10. Method according to one of the preceding claims,
wherein the liquid of the liquid volume (1) is applied with a flow when the small parts (3) are applied.

11. Method according to one of the preceding claims,
wherein a standing wave is generated by oscillation or vibration (111) on the liquid surface (5) and the small parts (3) are divided into groups or are isolated in that they slide into minima of the standing wave.

12. Arrangement device for arranging small parts (3)
having at least one liquid receiving region, in which a liquid volume (1) is able to be created,
at least one liquid connection (11) via which liquid is able to be introduced into the at least one liquid receiving region and/or is able to be drained and/or siphoned out from it, as well as having at least one depositing surface (9), on which small parts (3) are able to be deposited in an arrangement position, as well as a vibration device (111),
wherein a method according to one of the preceding claims is able to be implemented with the arrangement device.

13. Device according to the preceding claim,
wherein the at least one depositing surface (9) is formed as an upwardly open channel or as an indentation in a surface having an outline of the indentation which corresponds to an outline of the small parts (3).

14. Device according to one of the two preceding claims,
wherein at least one of the at least one depositing surfaces (9) is arranged at an upper edge of the liquid receiving region.

15. Device according to claim 13,
wherein the at least one depositing surface (9) is arranged in a centre of the liquid receiving region, preferably on a base (12) which is raised with respect to a bottom of the liquid receiving region.

## Revendications

1. Procédé d'arrangement de petites pièces, un volume de liquide (1) étant déposé avec au moins une surface de liquide (5) courbée au moins partiellement, et une pluralité de petites pièces (3) à séparer étant appliquée sur au moins une zone courbée de la surface de liquide (5)
les petites pièces (3) étant supportées, après l'application, du fait de la tension de surface et/ou de la flottabilité, par la surface de liquide (5),
**caractérisé en ce que**
du fait de la courbure de la surface de liquide (5), les petites pièces (3) se déplacent vers une position intermédiaire (4a, 4b),
les petites pièces (3) étant sollicitées, dans la position intermédiaire (4a, 4b), avec oscillation ou une vibration (111) grâce à laquelle ils se déplacent vers une position d'arrangement (112).

2. Procédé selon la revendication précédente,
le volume de liquide (1) avec une surface de liquide (5) convexe étant déposé sur une surface (2), de préférence une surface plane (2), de façon à ce qu'un bord du volume de liquide (1) s'étende dans le plan de la surface (2) ou sur la surface (2).

3. Procédé selon la revendication précédente,
la surface (2) présentant au moins une zone hydrophile et au moins une zone hydrophobe et le volume de liquide étant déposé dans la zone hydrophile et étant limité par la zone hydrophobe.

4. Procédé selon la revendication 1,
le volume de liquide (1) étant déposé dans une cavité avec une section transversale qui est de préférence, dans la direction horizontale, rectangulaire, carrée, elliptique ou circulaire, ou le volume de liquide étant déposé dans un angle.

5. Procédé selon la revendication précédente,
le volume de liquide (1) étant déposé avec une surface de liquide (5) concave et s'étendant en dessous d'un bord de la cavité ou
le volume de liquide (1) étant déposé avec une surface de liquide (5) convexe et s'étendant de préférence au moins partiellement au-dessus d'un bord de la cavité.

6. Procédé selon l'une des revendications précédentes,
le liquide étant évacué et/ou aspiré du volume de liquide (1) une fois que les petites pièces ont atteint la position d'arrangement (112), jusqu'à ce qu'une, de préférence toutes les petites pièces (3) se déposent sur au moins une surface de dépôt (9).

7. Procédé selon la revendication précédente,
le volume de liquide (1) étant déposé avec une surface de liquide (5) convexe et l'au moins une surface de dépôt (9) étant prévue au niveau d'un bord de la cavité ou le volume de liquide (1) étant déposé avec une surface de liquide (5) concave et la surface de dépôt (9) étant prévue en dessous d'un minimum de la surface de liquide (5) et/ou au centre de la cavité,
l'au moins une surface de dépôt (9) présentant au moins une barrière (10) par rapport à la cavité ou un emplacement d'évacuation ou d'aspiration du liquide, qui est perméable au liquide mais imperméable et/ou insurmontable pour les petites pièces (3).

8. Procédé selon l'une des revendications 6 ou 7,
l'au moins une surface de dépôt (9) étant conçue comme une goulotte ouverte vers le haut à partir de laquelle les petites pièces (3) sont aspirées, la goulotte étant en option recouverte après l'évacuation ou l'aspiration du liquide hors de la cavité, de façon à ce qu'un canal se forme, dans lequel les petites pièces (3) sont disposées et les petites pièces (3) étant aspirées hors du canal après le recouvrement.

9. Procédé selon l'une des revendications 7 ou 8,
l'au moins une surface de dépôt (9) présentant un contour correspondant au contour des petites pièces (3), de préférence la surface de dépôt (9) étant conçue comme un creux avec le contour correspondant sur une surface.

10. Procédé selon l'une des revendications précédentes,
le liquide du volume de liquide (1) étant sollicité pendant l'application des petites pièces (3), avec un écoulement.

11. Procédé selon l'une des revendications précédentes, l'oscillation ou la vibration (111) générant à la surface du liquide (5) une onde stationnaire et les petites pièces (3) étant ainsi divisées ou séparées en groupes, grâce au fait qu'elles glissent dans les minima de l'onde stationnaire.

12. Dispositif d'arrangement pour l'arrangement de petites pièces (3) avec au moins une zone de logement de liquide, dans laquelle un volume de liquide (1) peut être déposé,
au moins un raccord de liquide (11) par l'intermédiaire duquel un liquide peut être introduit dans l'au moins une zone de logement de liquide et/ou peut en être évacué et/ou aspiré, ainsi qu'avec au moins une surface de dépôt (9) sur laquelle les petites pièces (3) peuvent être déposées dans une position d'arrangement, ainsi qu'un dispositif de vibration (111),
un procédé selon l'une des revendications précédentes pouvant être réalisé avec le dispositif d'arrangement.

13. Dispositif selon la revendication précédente, l'au moins une surface de dépôt (9) étant conçue comme une goulotte ouverte vers le haut ou comme un creux dans une surface avec un contour du creux correspondant à un contour des petites pièces (3).

14. Dispositif selon l'une des revendications précédentes, au moins une des au moins une surfaces de dépôt (9) étant disposé au niveau d'un bord supérieur de la zone de logement de liquide.

15. Dispositif selon la revendication 13,
l'au moins une surface de dépôt (9) étant disposée dans un centre de la zone de logement de liquide, de préférence sur un socle (12) surélevé par rapport à fond de la zone de logement de liquide.
